(19) **Europäisches Patentamt European Patent Office Office européen des brevets**

(11) **EP 4 468 599 A1**

(12) **EUROPEAN PATENT APPLICATION**
published in accordance with Art. 153(4) EPC

(43) Date of publication:
27.11.2024 Bulletin 2024/48

(51) International Patent Classification (IPC):
$H03F\ 1/52$ (2006.01)     $H03F\ 3/213$ (2006.01)
$H03F\ 3/195$ (2006.01)

(21) Application number: 23742930.3

(22) Date of filing: 18.01.2023

(52) Cooperative Patent Classification (CPC):
H03F 3/195; H03F 1/52; H03F 1/565; H03F 3/213;
H03F 3/245

(86) International application number:
PCT/CN2023/072885

(87) International publication number:
WO 2023/138615 (27.07.2023 Gazette 2023/30)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 18.01.2022 CN 202210051858

(71) Applicant: Vanchip (Tianjin) Technology Co. Ltd
Tianjin 300457 (CN)

(72) Inventors:
• LI, Hao
  Tianjin 300457 (CN)
• BAI, Yunfang
  Tianjin 300457 (CN)

(74) Representative: Wang, Bo
Panovision IP
Ebersberger Straße 3
85570 Markt Schwaben (DE)

(54) **RADIO FREQUENCY FRONT-END MODULE HAVING CURRENT PROTECTION FUNCTION, AND ELECTRONIC DEVICE**

(57) Disclosed are a radio frequency front-end module having a current protection function, and an electronic device. The radio frequency front-end module comprises an input matching module, a power amplifier, an output matching module, a power supply module, and a protection unit. An input end of the input matching module is connected to an external radio frequency signal input end, an output end of the input matching module is connected to an input end of the power amplifier, an output end of the power amplifier is connected to an input end of the output matching module, and an output end of the output matching module is connected to a radio frequency signal output end; output ends of the power supply module and the protection unit are respectively connected to the power amplifier. The protection unit can achieve the effects of current protection, voltage protection and power protection for the power amplifier in the radio frequency front-end module, so that the reliability and safety for the radio frequency front-end module to operate in a severe environment are improved.

FIG. 2

EP 4 468 599 A1

## Description

## BACKGROUND

**Technical Field**

The present disclosure relates to a radio frequency front-end module having a current protection function and also relates to an electronic device including the radio frequency front-end module, and belongs to the technical field of radio frequency integrated circuits.

**Related Art**

With the continuous development of the integrated circuit technology, modern electronic devices have increasingly high requirements for radio frequency front-end modules, and particularly, there are more and more scenarios where operation is performed in harsh environments. For example, the temperature in the working environment may rise or fall to reach or exceed the required temperature range limit (typically, the temperature range is -25°C to 85°C or -40°C to 110°C). When a power apparatus works in the high-temperature or low-temperature environment, a safety working area of the power apparatus becomes smaller, and even when working current on the power apparatus exceeds its maximum current rating, irreversible damage or destruction to the power apparatus can occur. Thus, in order to ensure the normal operation of the power apparatus, it is necessary to implement appropriate protective measures to limit the excessive working current of the power apparatus in harsh environmental scenarios, thereby ensuring that the power apparatus always works within the safety working area.

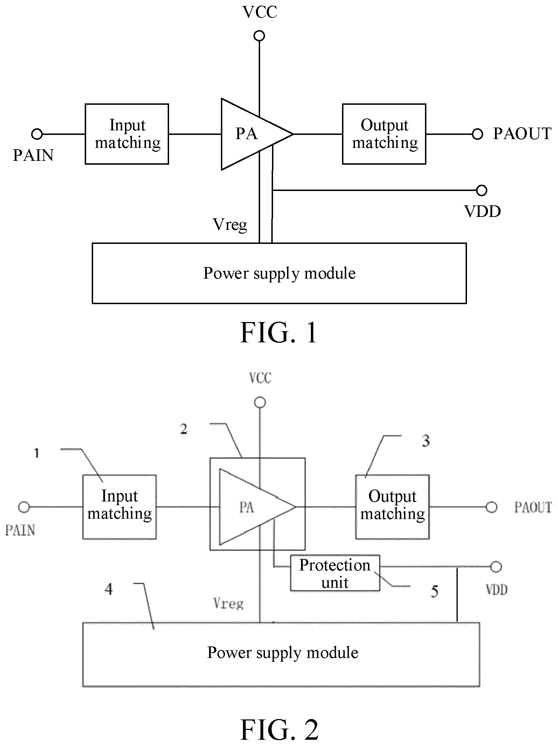

As shown in FIG. 1, a typical radio frequency front-end module in the prior art includes an input matching module, a power amplifier (PA), an output matching module, and a power supply module. The power amplifier usually includes two or three stages of power amplification units, which are main power apparatuses for current protection.

In the American patent application No. US2009256637A1, a high-frequency power amplifier is disclosed. A high-frequency power amplifier circuit in the fourth embodiment includes high-frequency power amplifier transistors, matching circuits, bias supply transistors, and passive elements. The passive elements are connected between a common power supply terminal and collectors of the bias supply transistors, and the bias supply transistors are connected to a first-stage transistor. The passive element is implemented by connecting a resistor and an inductor. In the high-frequency power amplifier circuit, the passive elements prevent reduction of electric power of the bias supply transistors, so as to improve linearity at high output.

## SUMMARY

The technical problem required to be solved by the present disclosure is to provide a radio frequency front-end module having a current protection function.

Another technical problem required to be solved by the present disclosure is to provide an electronic device including the radio frequency front-end module.

In order to achieve the above objectives, the present disclosure adopts following technical solutions:
According to a first aspect of an embodiment of the present disclosure, a radio frequency front-end module having a current protection function is provided, and includes an input matching module, a power amplifier, an output matching module, a power supply module and a protection unit, wherein

an input end of the input matching module is connected with an external radio frequency signal input end, and an output end is connected with an input end of the power amplifier, so as to realize impedance matching between the power amplifier and the external radio frequency signal input end;
the power amplifier is used for amplifying power of input radio frequency signals, and an input end of the power amplifier is connected with an input end of the output matching module;
an output end of the output matching module is connected with a radio frequency signal output end, so as to realize power matching between the power amplifier and the radio frequency signal output end; and
an output end of the protection unit is connected with the power amplifier, and current of the power amplifier is limited by a threshold voltage generated by the protection unit, so as to realize current protection.

Preferably, the protection unit includes at least one current limiting resistor and one filter capacitor, wherein the current limiting resistor is used for generating the threshold voltage, and the filter capacitor is used for showing a low-resistance state at radio frequency and envelope signal frequency, such that the threshold voltage cannot change along with radio frequency signals and envelope signals.

Preferably, the protection unit further includes a trap circuit, and the trap circuit is connected with the filter capacitor in parallel.

Preferably, the power amplifier includes at least one stage of power amplification unit. The power amplification unit includes a bias circuit and a power amplification circuit. The protection unit is at least connected with the bias circuit of the at least one stage of power amplification unit.

Preferably, the bias circuit includes a first transistor, a second transistor, a third transistor, a first bias resistor and a first filter capacitor; the power amplification circuit includes a fourth transistor, a first ballast resistor and a first inductor; and the protection unit includes a first current limiting resistor and a second filter capacitor, wherein an emitter of the third transistor is connected with a ground potential end, and a base and a collector of the third transistor are in short-circuiting connection, and then are connected with an emitter of the second transistor; a base and a collector of the second transistor are in short-circuiting connection, then are connected with the first bias resistor, and are also connected with a base of the first transistor and the first filter capacitor; the other end of the first bias resistor is connected with a bias power supply, and the other end of the first filter capacitor is connected with the ground potential end; a collector of the first transistor is connected with the second filter capacitor and the first current limiting resistor, the other end of the second filter capacitor is connected with the ground potential end, and the other end of the first current limiting resistor is connected with a second power supply end; an emitter of the first transistor is connected with the first ballast resistor, the other end of the first ballast resistor is connected with an input end and is also connected with a base of the fourth transistor; an emitter of the fourth transistor is connected with the ground potential end, a collector of the fourth transistor is connected with an output end, and is also connected with the first inductor, and the other end of the first inductor is connected with a first power supply end.

Preferably, when the bias circuit, the power amplification circuit and the protection unit satisfy following formulas, the bias circuit and the power amplification circuit enter a current limiting protection working state:

$$V_{1C} < V_{1b} - V_{th\_bc}$$

$$V_{1C} = VDD - V_R$$

$$V_R = I_1 * R$$

$V_{1c}$ denotes a collector voltage of the first transistor, $V_{1b}$ denotes a base voltage of the first transistor, $V_{th\_bc}$ denotes a threshold voltage between the base and the collector of the first transistor, $V_R$ denotes a voltage drop on the first current limiting resistor, Ii denotes a collector current of the first transistor, R denotes a resistance value of the first current limiting resistor, and VDD denotes a voltage of a second power supply.

Preferably, a thermistor with a temperature coefficient is adopted as the current limiting resistor of the protection unit; for a power amplifier likely to burn out at a low temperature, a thermistor with a negative temperature coefficient is adopted as the current limiting resistor; and for a power amplifier likely to burn out at a high temperature, a thermistor with a positive temperature coefficient is adopted as the current limiting resistor.

Preferably, the protection unit includes a plurality of different-size filter capacitors with capacitance values ranging from pF to uF, so as to filter radio frequency signals and envelope signals different in frequency and realize broadband filtering.

Preferably, a stabilized voltage supply with a temperature coefficient is adopted as a power supply connected with the first current limiting resistor in the protection unit; for the power amplifier likely to burn out at the low temperature, a stabilized voltage supply with a positive temperature coefficient is adopted as the power supply; and for the power amplifier likely to burn out at the high temperature, a stabilized voltage supply with a negative temperature coefficient is adopted as the power supply.

Preferably, the trap circuit is additionally arranged in the protection unit and formed by connecting one inductor and one capacitor in series, and the trap circuit and the second filter capacitor are connected in parallel. An inductor end of the trap circuit is connected with node ends of the first current limiting resistor and the second filter capacitor, and a capacitor end is connected with the ground potential end.

Preferably, the protection unit further includes an inductor constituting an RLC combined circuit together with the current limiting resistor and the filter capacitor, to further filter the radio frequency signals and the envelope signals.

Preferably, the RLC combined circuit includes an eleventh inductor, the current limiting resistor, an eleventh capacitor and a twelfth capacitor.

One end of the current limiting resistor is connected with the collector of the first transistor in the bias circuit, and is also connected with the eleventh capacitor; the other end of the current limiting resistor is connected with the eleventh inductor and is also connected with the twelfth capacitor; the other end of the eleventh inductor is connected with the second power supply end; and the other end of the eleventh capacitor and the other end of the twelfth capacitor are respectively connected with the ground potential end.

Preferably, a control switch is further included and connected to two ends of the protection unit in parallel, so as to realize turn-on or turn off of the protection unit; and a control signal end of the control switch is connected with the first power supply end or an output end of a power detection circuit.

According to a second aspect of the embodiment of the present disclosure, an electronic device is provided, and includes the above radio frequency front-end module having a current protection function.

Compared with the prior art, the radio frequency front-end module having a current protection function provided by the embodiment of the present disclosure can have the functions of over-current protection, over-voltage protection and overpower protection on the power amplifier through additional arrangement of the protection unit, such that working reliability and safety of the radio frequency front-end module in harsh environments are greatly improved. Meanwhile, the protection unit realizes the threshold voltage only by utilizing voltage drop changes of the current limiting resistor without causing additional circuit power consumption or occupying a large circuit area, and thus, the radio frequency front-end module having a current protection function provided by the present disclosure has the beneficial effects of being ingenious and reasonable in structural design, low in design cost, high in reliability, excellent in circuit perform, etc., and is applicable to various structures of radio frequency front-end modules.

## BRIEF DESCRIPTION OF THE DRAWINGS

FIG. 1 is a structural block diagram of a typical radio frequency front-end module in the prior art;

FIG. 2 is a structural block diagram of a radio frequency front-end module having a current protection function according to an embodiment of the present invention;

FIG. 3 is a schematic structural diagram of a power amplifier, a power supply module and a protection unit according to a first embodiment of the present disclosure;

FIG. 4(a) is a schematic circuit diagram of an amplification unit and the protection unit according to the first embodiment of the present disclosure;

FIG. 4(b) is another schematic circuit diagram of the amplification unit and the protection unit according to the first embodiment of the present disclosure;

FIG. 5 is a schematic structural diagram of the protection unit providing over-current protection for last two stages of power amplification units according to the first embodiment of the present disclosure;

FIG. 6 is a schematic structural diagram of the protection unit providing over-current protection for the final stage of power amplification unit according to the first embodiment of the present disclosure;

FIG. 7 is a schematic circuit diagram of an amplification unit and a protection unit according to a second embodiment of the present disclosure;

FIG. 8 is a schematic structural diagram of a power amplifier, a power supply module and the protection unit according to the second embodiment of the present disclosure;

FIG. 9 is a schematic structural diagram of the protection unit providing over-current protection for last two stages of power amplification units according to the second embodiment of the present disclosure;

FIG. 10 is a schematic structural diagram of the protection unit providing over-current protection for the final stage of power amplification unit according to the second embodiment of the present disclosure;

FIG. 11 is a schematic circuit diagram of an amplification unit and a protection unit according to a third embodiment of the present disclosure;

FIG. 12 is a first schematic structural diagram of the protection unit with a control switch according to the third embodiment of the present disclosure;

FIG. 13 is a second schematic structural diagram of the protection unit with the control switch according to the third embodiment of the present disclosure;

FIG. 14 is a relation curve graph of input power and output current of a power amplification circuit in a technical solution provided by an embodiment of the present disclosure; and

FIG. 15 is an example diagram of an electronic device adopting the radio frequency front-end module according to the embodiment of the present disclosure.

## DETAILED DESCRIPTION

The technical content of the present disclosure is specifically described in detail in combination with drawings and specific embodiments as below.

As shown in FIG. 2, a radio frequency front-end module having a current protection function according to an embodiment of the present disclosure includes an input matching module 1, a power amplifier 2, an output matching module 3, a power supply module 4 and a protection unit 5. An input end of the input matching module 1 is connected with an external radio frequency signal input end PA IN, an output end of the input matching module 1 is connected with an input end of the power amplifier 2, an output end of the power amplifier 2 is connected with an input end of the output matching module 3, an output end of the output matching module 3 is connected with a radio frequency signal output end PA OUT, and the power supply module 4 and the protection unit 5 are respectively connected with the power amplifier 2.

The input matching module 1 is used for realizing impedance matching between the power amplifier 2 and the radio frequency signal input end PA IN. The power amplifier 2 is used for amplifying power of input radio frequency signals, and includes at least one stage of power amplification unit, and the power amplification unit includes a bias circuit and a power amplification circuit. The output matching module 3 is used for realizing power matching between the power amplifier 2 and the radio frequency signal output end PA OUT. The power supply module 4 provides bias current and voltage required for working of the power amplifier 2. The protection unit 5 provides current protection for the power amplifier 2 and is connected with the bias circuit of the at least one stage of power amplification unit. The protection unit 5 includes at least one current limiting resistor and one filter capacitor.

A power supply VCC provides power voltage and current for a power amplifier, and a power supply VDD provides power voltage and current for the bias circuit and the power supply module 4 in the power amplifier. Usually, the power supply VCC and the power supply VDD are both powered by an external power supply module.

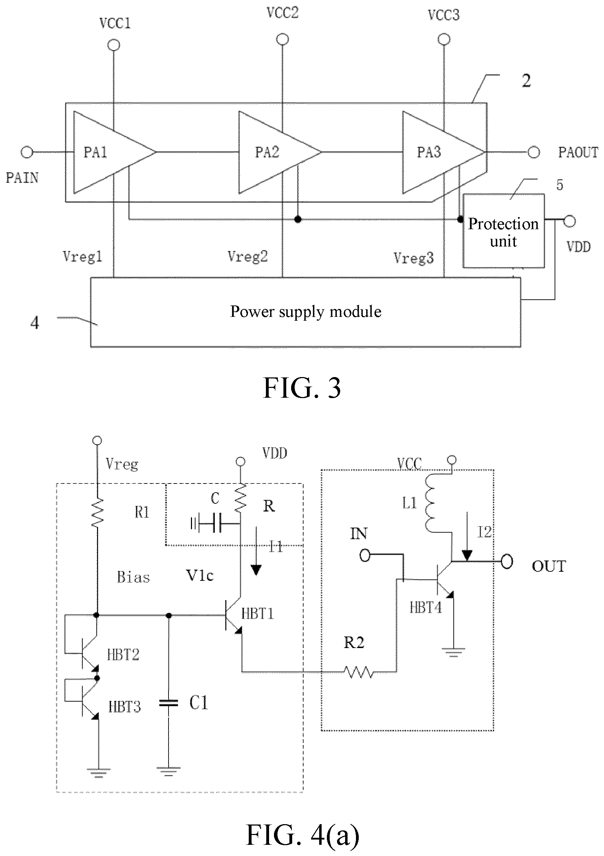

In a first embodiment of the present disclosure, specific circuits of the power amplifier 2, the power supply module 4 and the protection unit 5 are shown in FIG. 3. The power amplifier 2 includes three stages of power amplification units, respectively including a first-stage power amplification unit PA1, a second-stage power amplification unit PA2 and a third-stage power amplification unit PA3, which are sequentially cascaded. A first power supply Vreg1, a second power supply Vreg2 and a third power supply Vreg3 output by the power supply module 4 are respectively in corresponding connection with bias power supply ends of the first-stage power amplification unit PA1, the second-stage power amplification unit PA2 and the third-stage power amplification unit PA3. One end of the protection unit 5 is connected with the power supply VDD, and the other end is respectively connected with bias circuits of the first-stage power amplification unit PA1, the second-stage power amplification unit PA2 and the third-stage power amplification unit PA3.

In the first embodiment of the present disclosure, a circuit structure of any one of the three stages of power amplification units and a protection unit is shown in FIG. 4(a). The power amplification unit includes the bias circuit and the power amplification circuit. The bias circuit includes a first transistor HBT1, a second transistor HBT2, a third transistor HBT3, a first bias resistor R1 and a first filter capacitor C1. The power amplification circuit includes a fourth transistor HBT4, a first ballast resistor R2 and a first inductor L1. The protection unit includes a first current limiting resistor R and a second filter capacitor C. The second transistor HBT2 and the third transistor HBT3 constitute a double diode. An emitter of the third transistor HBT3 is connected with a ground potential end, and a base and a collector of the third transistor HBT3 are in short-circuiting connection, and then are connected with an emitter of the second transistor HBT2. A base and a collector of the second transistor HBT2 are in short-circuiting connection, then are connected with the first bias resistor R1, and are also connected with a base of the first transistor HBT1 and the first filter capacitor C1. The other end of the first bias resistor R1 is connected with a bias power supply Vreg, and the other end of the first filter capacitor C1 is connected with the ground potential end. A collector of the first transistor HBT1 is connected with the second filter capacitor C and the first current limiting resistor R, the other end of the second filter capacitor C is connected with the ground potential end, and the other end of the first current limiting resistor R is connected with the power supply VDD. An emitter of the first transistor HBT1 is connected with the first ballast resistor R2, the other end of the first ballast resistor R2 is connected with an input end IN and is also connected with a base of the fourth transistor HBT4, an emitter of the fourth transistor HBT4 is connected with the ground potential end, a collector of the fourth transistor HBT4 is connected with an output end OUT, and is also connected with the first inductor L1, and the other end of the first inductor L1 is connected with the power supply VCC.

The working principle of the radio frequency front-end module having a current protection function in the above first embodiment is as follows:

As shown in FIG. 4(a), during normal working, the bias circuit, the power amplification circuit and the protection unit satisfy following formulas:

$$I_2 \approx \beta * I_1 \qquad\qquad (1)$$

$$V_R = I_1 * R \qquad\qquad (2)$$

$$V_{1C} = VDD - V_R \qquad\qquad (3)$$

$$V_{1C} > V_{1b} - V_{th\_bc} \qquad\qquad (4)$$

$V_{1c}$ denotes a collector voltage of the first transistor HBT1, $V_{1b}$ denotes a base voltage of the first transistor HBT1, $V_{th\_bc}$ denotes a threshold voltage between the base and the collector of the first transistor HBT1, $V_R$ denotes a voltage drop on the first current limiting resistor R, Ii denotes a collector current of the first transistor HBT1, $I_2$ denotes a collector current of the fourth transistor HBT4, R denotes a resistance value of the first current limiting resistor R, β denotes an amplification coefficient of the fourth transistor HBT4, and VDD denotes a voltage value of the power supply VDD. At the time, the bias circuit and the power amplification circuit do not enter a current limiting protection state, and the formula 4 shows a starting work condition of the first transistor HBT1.

When the current $I_2$ of the fourth transistor HBT4 is increased through an external circuit, the first transistor HBT1 is required to provide larger output current Ii according to the formula 1. At the time, due to the increased current Ii, according to the formula 2 and the formula 3, voltage drop $V_R$ of the first current limiting resistor R is increased, a collector voltage $V_{1C}$ of the first transistor HBT1 is reduced, and when $V_{1C}$ is reduced to $V_{1C} < V_{1b} - V_{th\_bc}$, the current Ii is sharply reduced, and accordingly, the current $I_2$ is reduced, thereby realizing an over-current protection function of the circuit. In other words, when $V_{1C} < V_{1b} - V_{th\_bc}$, the bias circuit and the power amplification circuit enter a current-limiting protection working state. Usually, in the GaAs HBT technology, $V_{th\_bc}$ is 1.2 V, $V_{1b}$ is 2.4 V, and thus, when $V_{1C} < 1.2V$, the bias circuit and the power amplification circuit enter the current-limiting protection working state.

The voltage drop $V_R$ on the first current limiting resistor R in the protection unit serves as a threshold voltage to limit a maximum current of the power amplification circuit, thereby realizing a current protection function. In addition, the second filter capacitor C plays a filtering role, which is in a low-resistance state at radio frequency and envelope signal frequency, such that the voltage drop $V_R$ on the first current limiting resistor R cannot change along with changes of radio frequency signals and envelope signals, thereby ensuring that the first transistor HBT1 is in a stable working state.

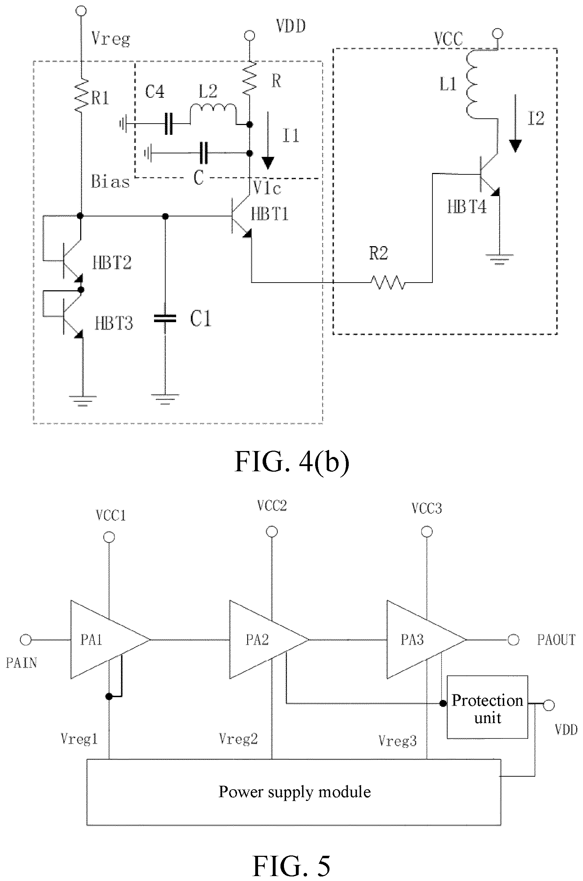

As shown in FIG. 4(b), a trap circuit formed by connecting a second inductor L2 and a third capacitor C4 in series may alternatively be additionally arranged in the protection unit in the above embodiment, and the trap circuit is connected with the second filter capacitor C in parallel. An inductor (L2) end is connected with node ends of the first current limiting resistor R and the second filter capacitor C, and a capacitor end (C4) is connected with the ground potential end. The trap circuit and the second filter capacitor are both used for restraining radio frequency and envelope signal frequency, and are in a low-resistance state at the radio frequency and the envelope signal frequency, thereby filtering the radio frequency signals and the envelope signals, and meanwhile implementing broadband filtering.

According to the technical solution provided by the first embodiment, there may be different variation examples for the circuit structure of the power amplifier, a power supply module and the protection unit in FIG. 3 according to different requirements for the circuit performance. For example, the power amplifier is not limited to be formed by cascading three stages of power amplification units, which may alternatively be formed by cascading one, two, or even multiple stages of power amplification units together, so as to realize the technical solution provided by the present disclosure. There may also be different variation examples for the bias circuits shown in FIG. 4(a) and FIG. 4(b), which is not limited herein.

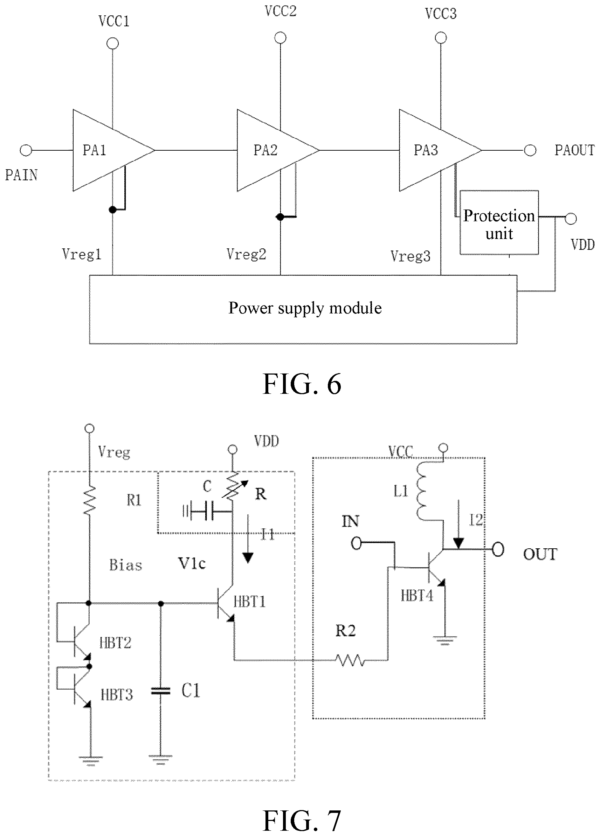

In addition, in the technical solution shown in FIG. 3, the protection unit provides over-current protection for all the three stages of power amplification units. As shown in FIG. 5, the protection unit may alternatively provide over-current protection only for last two stages of power amplification units. An output end of the protection unit is respectively connected with bias circuits of the last two stages of power amplification units PA2 and PA3. As shown in FIG. 6, the protection unit may alternatively provide over-current protection only for the final stage of power amplification unit. The output end of the protection unit is connected with the bias circuit of the final stage of the power amplification unit PA3.

It needs to be explained that according to actual requirements of the power amplification circuit, the protection unit may include but not limited to one filter capacitor, which may alternatively include a plurality of different-size capacitors with capacitance values ranging from pF to uF, so as to filter radio frequency signals different in frequency and realize the effect of broadband filtering.

In a second embodiment of the present disclosure, for the situation of power apparatus damage or destruction due to great rise or fall of the working environment temperature, the power amplifier 2, the power supply module 4 and the protection unit 5 in the radio frequency front-end module may adopt two following technical solutions to solve the problem about over-current protection.

As shown in FIG. 7, the protection unit in the first technical solution is composed of the first current limiting resistor R and the second filter capacitor C, and the first current limiting resistor R is a thermistor with a temperature coefficient. For a power amplification circuit likely to burn out at the low temperature, a thermistor with a negative temperature coefficient is selected as the first current limiting resistor R. For a power amplification circuit likely to burn out at the high temperature, a thermistor with a positive temperature coefficient is selected as the first current limiting resistor R. A specific working principle for realizing over-current protection is as below:

assuming that the circuit is the power amplification circuit likely to burn out at the low temperature, and the thermistor with the negative temperature coefficient is selected as the first current limiting resistor R, when the temperature is reduced, the resistance value of the first current limiting resistor R is increased, at the time, according to the formula 1, the formula 2 and the formula 3, the voltage drop $V_R$ of the first current limiting resistor R is increased, the collector voltage $V_{1C}$ of the first thermistor HBT1 is reduced, and when $V_{1C}$ is reduced to $V_{1C}<V_{1b}-V_{th\_bc}$, the current Ii is sharply reduced, and the current $I_2$ is reduced as well, thereby realizing the over-current protection function on the power amplification circuit likely to burn out at the low temperature. Compared with the first current limiting resistor being a common resistor, the thermistor with the negative temperature coefficient is adopted as the first current limiting resistor, protection start time can be shortened, and the protection function is further enhanced.

Assuming that the circuit is the power amplification circuit likely to burn out at the high temperature, and the thermistor with the positive temperature coefficient is selected as the first current limiting resistor R, when the temperature is increased, the resistance value of the first current limiting resistor R is increased, at the time, according to the formula 1, the formula 2 and the formula 3, the voltage drop $V_R$ of the first current limiting resistor R is increased, the collector voltage $V_{1C}$ of the first thermistor HBT1 is reduced, and when $V_{1C}$ is reduced to $V_{1C}<V_{1b}-V_{th\_bc}$, the current Ii is sharply reduced, and the current $I_2$ is reduced as well, thereby realizing the over-current protection function on the power amplification circuit likely to burn out at the high temperature. Compared with the first current limiting resistor being the common resistor, the thermistor with the positive temperature coefficient is adopted as the first current limiting resistor, protection start time can be shortened, and the protection function is further enhanced.

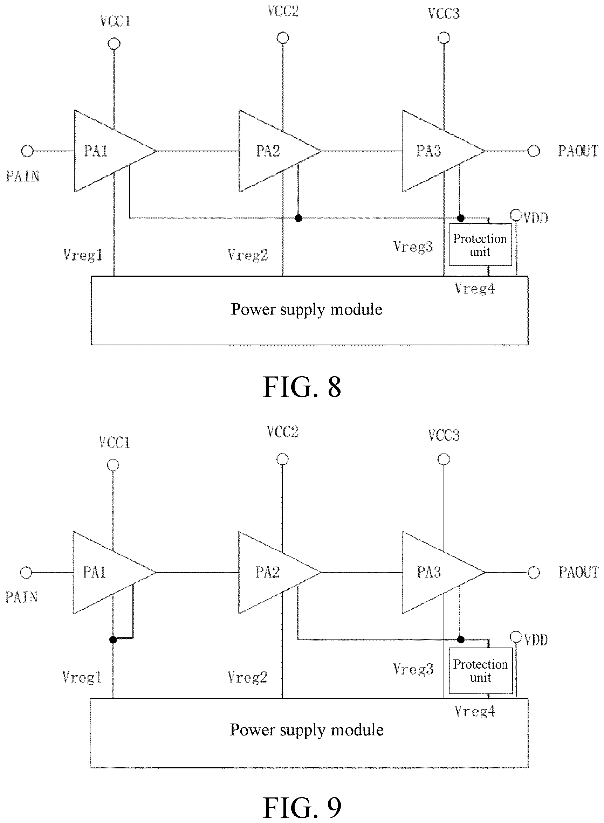

As shown in FIG. 8, a bias power supply Vreg4 in the second technical solution is a bias power supply having a temperature coefficient and output by the power supply module, which supplies power to the bias circuits of all the three stages of power amplification units through the protection unit. For the power amplification circuit likely to burn out at the low temperature, a stabilized voltage supply with a positive temperature coefficient is selected as the bias power supply Vreg4; and for the power amplification circuit likely to burn out at the high temperature, a stabilized voltage supply with a negative temperature coefficient is selected as the bias power supply Vreg4 A working principle for over-current protection is as below:

assuming that the circuit is the power amplification circuit likely to burn out at the low temperature, and the stabilized voltage supply with the positive temperature coefficient is selected as the bias power supply Vreg4, when the temperature is reduced, voltage output of the bias power supply Vreg4 is reduced, at the time, according to the formula 1 and the formula 3 (at the time, Vreg4 replaces VDD in the formulas), the collector voltage $V_{1C}$ of the first transistor HBT1 is reduced, and when $V_{1C}$ is reduced to $V_{1C}<V_{1b}-V_{th\_bc}$, the current Ii is sharply reduced, and the current $I_2$ is reduced as well, thereby realizing the over-current protection function on the power amplification circuit likely to burn out at the low temperature. Compared with a constant power supply VDD, the stabilized voltage supply with the positive temperature coefficient is selected as the bias power supply Vreg4, protection start time can be shortened, and the protection function is further enhanced.

Assuming that the circuit is the power amplification circuit likely to burn out at the high temperature, and the stabilized voltage supply with the negative temperature coefficient is selected as the bias power supply Vreg4, when the temperature is increased, voltage output of the bias power supply Vreg4 is reduced, at the time, according to the formula 1 and the formula 3 (at the time, Vreg4 replaces VDD in the formulas), the collector voltage $V_{1C}$ of the first transistor HBT1 is reduced, and when $V_{1C}$ is reduced to $V_{1C}<V_{1b}-V_{th\_bc}$, the current Ii is sharply reduced, and the current $I_2$ is reduced as well, thereby realizing the over-current protection function on the power amplification circuit likely to burn out at the high temperature. Compared with the constant power supply VDD, the stabilized voltage supply with the negative temperature coefficient is selected as the bias power supply Vreg4, protection start time can be shortened, and the protection function is further enhanced.

According to the technical solution provided by the second embodiment, there may also be different variation examples for the circuit structure of the power amplifier, the power supply module and the protection unit according to different requirements for the circuit performance. For example, the power amplifier is not limited to be formed by cascading three stages of power amplification units, which may alternatively be formed by cascading one, two, or even multiple stages of power amplification units together, so as to realize the technical solution provided by the present disclosure.

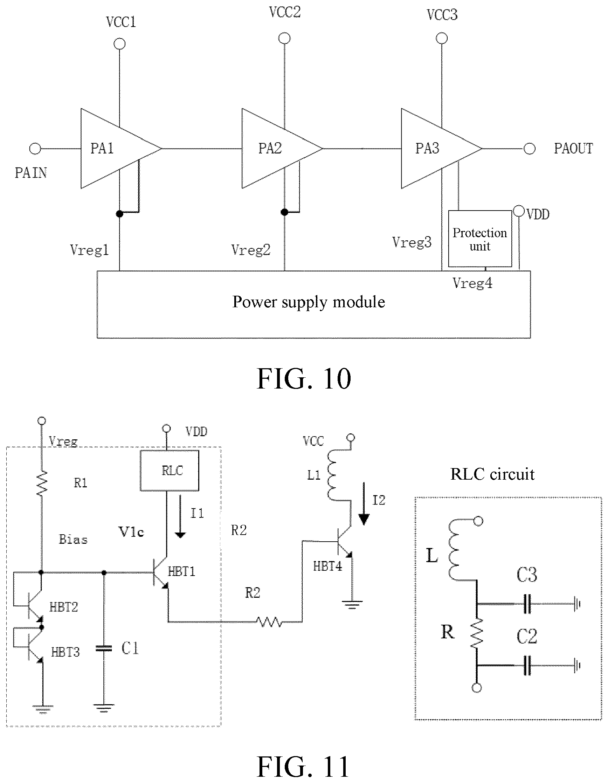

In addition, in the technical solution shown in FIG. 8, the protection unit provides over-current protection for all the three stages of power amplification units. As shown in FIG. 9, the protection unit may alternatively provide over-current protection only for the last two stages of power amplification units. The protection unit is composed of a first current limiting resistor and a second filter capacitor, one end of the first current limiting resistor and one end of the second filter capacitor are respectively connected with bias circuits of the last two stages of power amplification units PA2 and PA3, and the other end of the first current limiting resistor is connected with the bias power supply Vreg4 with the temperature coefficient. As shown in FIG. 10, the protection unit may alternatively provide over-current protection only for the final stage of power amplification unit. The protection unit is composed of a first current limiting resistor and a second filter capacitor, one end of the first current limiting resistor and one end of the second filter capacitor are connected with the bias circuit of the final stage of the power amplification unit PA3, and the other end of the first current limiting resistor is connected with the bias power supply Vreg4 with the temperature coefficient.

In a third embodiment of the present disclosure, as shown in FIG. 11, when there is a problem about radio frequency impedance matching affecting the circuit perform, the protection unit in the radio frequency front-end module may alternatively be realized by a resistor-inductor-capacitor (RLC) combined circuit. The RLC combined circuit is composed of an eleventh inductor L, an eleventh resistor R (i.e., a current limiting resistor), an eleventh capacitor C2 and a twelfth capacitor C3. One end of the eleventh resistor R is connected with the collector of the first transistor HBT1 in the bias circuit, and is also connected with the eleventh capacitor C2. The other end of the eleventh resistor R is connected with the eleventh inductor L, and is also connected with the twelfth capacitor C3. The other end of the eleventh inductor L is connected with the power supply VDD. The other end of the eleventh capacitor C2 and the other end of the twelfth capacitor C3 are respectively connected with the ground potential end.

In the RLC combined circuit, the eleventh resistor R is the current limiting resistor, and the eleventh capacitor C2 and the twelfth capacitor C3 are both filter capacitors. It needs to be explained that the RLC combined circuit may alternatively be combined in other forms, but includes at least one current limiting resistor and one filter capacitor.

In addition, the RLC combined circuit may alternatively implement turn-on and turn-off of the protection unit through a control switch SW, and the control switch SW can be turned on at high power or high current or high voltage to limit current, such that the RLC combined circuit cannot affect working performance of the power amplifier under normal conditions.

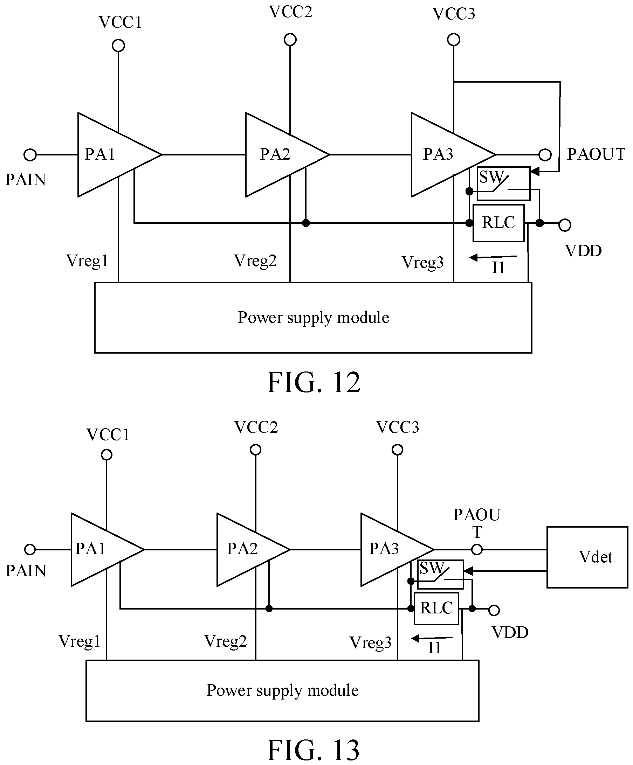

As shown in FIG. 12, the protection unit is implemented by the RLC combined circuit, the control switch SW is connected to two ends of the RLC combined circuit in parallel, and a control signal end of the control switch SW is connected with a power supply VCC3. During normal working, the control switch SW is closed, such that the protection unit exits the working state, so as to not affect the working performance of the power amplifier. When the voltage of the power supply VCC3 is increased and reaches a certain threshold, the control switch SW is opened, such that the RLC combined circuit works, so as to achieve a protection function of limiting circuit over-voltage.

As shown in FIG. 13, the protection unit is implemented by the RLC combined circuit, the control switch SW is connected to the two ends of the RLC combined circuit in parallel, and the control signal end of the control switch SW is connected with an output end of a power detection circuit Vdet. During normal working, the control switch SW is closed, such that the protection unit exits the working state, so as to not affect the working performance of the power amplifier. When the output power of the power detection circuit Vdet is increased and reaches a certain threshold, the control switch SW is opened, such that the RLC combined circuit works, so as to achieve a protection function of limiting circuit overpower.

The technical solution provided by the above third embodiment may alternatively be similarly applicable to the circuit structures of the first embodiment and the second embodiment according to specific circuit requirements, and one control switch SW is connected to the two ends of the protection unit in parallel to realize turn-on and turn-off of the protection unit, thereby achieving functions of optimizing a circuit protection function and working performance.

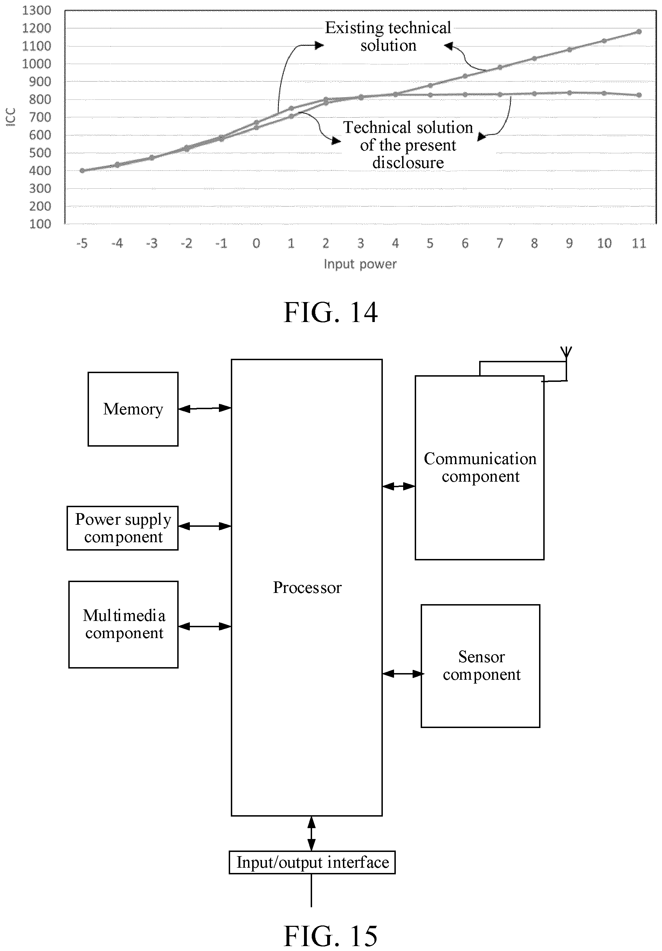

To verify the technical effects of the radio frequency front-end module provided by the embodiment of the present disclosure, the inventors perform input power and output current simulation tests on the technical solution of the present disclosure and the existing technical solution (without the protection unit). The test results are shown in FIG. 14, an x-coordinate represents input power, and a y-coordinate represents output current. It can be seen from FIG. 14 that as the input power continues to increase, the output current in the power amplification circuit in existing technical solution continuously rises along with the increase in input power; but in the power amplification circuit having a current protection function in the present disclosure, as the input power continues to increase, the output current is constantly limited at about 800 mA, thereby realizing over-current protection on the power amplification circuit.

The radio frequency front-end module having a current protection function provided by the present disclosure may be applied to an electronic device to serve as an important part of a communication component. The electronic device described herein refers to a computer device that is used in a mobile environment and supports a plurality of communication standards including GSM, EDGE, TD_SCDMA, TDD_LTE, FDD_LTE, 5G, etc., and the electronic device may be a mobile phone, a notebook computer, a tablet, an on-board computer, etc. In addition, the technical solutions provided by the embodiments of the present disclosure are also applicable to other radio frequency integrated circuit application occasions, such as a communication base station, and intelligent connected vehicles.

As shown in FIG. 15, the electronic device includes at least a processor, a communication component and a memory, and may further include a sensor component, a power supply component, a multimedia component, and an input/output interface according to actual needs. The memory, the communication component, the sensor component, the power supply component, the multimedia component and the input/output interface are all connected with the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, etc. The processor may be a central processing unit (CPU), a graphics processing unit (GPU), a field programmable gate array (FPGA), an application specific integrated circuit (ASIC), a digital signal processing (DSP) chip, etc. Other communication components, sensor components, power supply components, multimedia components, etc. all can be implemented by universal parts, which are not specifically described herein.

Through the detailed descriptions of the technical solution of the present disclosure according to the above embodiments, it can be seen that compared with the prior art, the radio frequency front-end module having a current protection function provided by the embodiment of the present disclosure can have the functions of over-current protection, over-voltage protection and overpower protection on the power amplifier through additional arrangement of the protection unit, such that working reliability and safety of the radio frequency front-end module in harsh environments are greatly improved. Meanwhile, the protection unit realizes the threshold voltage only by utilizing voltage drop changes of the current limiting resistor without causing additional circuit power consumption or occupying a large circuit area, and thus, the radio frequency front-end module having a current protection function provided by the present disclosure has the beneficial effects of being ingenious and reasonable in structural design, low in design cost, high in reliability, excellent in circuit perform, etc., and is applicable to various structures of radio frequency front-end modules.

It needs to be explained that the above multiple embodiments are only illustrative, and the technical solutions of the various embodiments may be combined and are all within the scope of the protection of the present disclosure.

In addition, the terms "first" and "second" are only used for descriptive purposes, and cannot be construed as indicating or implying relative importance or implicitly indicating the number of technical features indicated. Thus, features limited with "first" and "second" may explicitly or implicitly include one or more features. In the description of the present disclosure, "a plurality of" means two or more, unless otherwise explicitly and specifically defined.

The radio frequency front-end module having a current protection function, and the electronic device provided by the present disclosure are described in detail above. For those of ordinary skill in the art, any obvious modification made without departing from the essential contents of the present disclosure will constitute an infringement of the patent rights of the present disclosure, and the corresponding legal responsibilities should be borne.

**Claims**

1. A radio frequency front-end module having a current protection function, comprising: an input matching module, a power amplifier, an output matching module and a power supply module, and further comprising a protection unit, wherein

   an input end of the input matching module is connected with an external radio frequency signal input end, and an output end is connected with an input end of the power amplifier, so as to realize impedance matching between the power amplifier and the external radio frequency signal input end;
   the power amplifier is used for amplifying power of input radio frequency signals, and an input end of the power amplifier is connected with an input end of the output matching module;
   an output end of the output matching module is connected with a radio frequency signal output end, so as to realize power matching between the power amplifier and the radio frequency signal output end; and
   an output end of the protection unit is connected with the power amplifier, and current of the power amplifier is limited by a threshold voltage generated by the protection unit, so as to realize current protection.

2. The radio frequency front-end module having a current protection function according to claim 1, wherein

   the protection unit comprises at least one current limiting resistor and one filter capacitor,
   the current limiting resistor being used for generating the threshold voltage, and the filter capacitor being used for showing a low-resistance state at radio frequency and envelope signal frequency, such that the threshold voltage cannot change along with radio frequency signals and envelope signals.

3. The radio frequency front-end module having a current protection function according to claim 2, wherein the protection unit further comprises a trap circuit, the trap circuit being connected with the filter capacitor in parallel.

4. The radio frequency front-end module having a current protection function according to claim 1, wherein the power amplifier comprises at least one stage of power amplification unit, the power amplification unit comprises a bias circuit and a power amplification circuit, and the protection unit is at least connected with the bias circuit of the at least one stage of power amplification unit.

5. The radio frequency front-end module having a current protection function according to claim 4, wherein

   the bias circuit comprises a first transistor, a second transistor, a third transistor, a first bias resistor and a first filter capacitor; the power amplification circuit comprises a fourth transistor, a first ballast resistor and a first inductor;

and the protection unit comprises a first current limiting resistor and a second filter capacitor, wherein an emitter of the third transistor is connected with a ground potential end, and a base and a collector of the third transistor are in short-circuiting connection, and then are connected with an emitter of the second transistor; a base and a collector of the second transistor are in short-circuiting connection, then are connected with the first bias resistor, and are further connected with a base of the first transistor and the first filter capacitor; the other end of the first bias resistor is connected with a bias power supply, and the other end of the first filter capacitor is connected with the ground potential end; a collector of the first transistor is connected with the second filter capacitor and the first current limiting resistor, the other end of the second filter capacitor is connected with the ground potential end, and the other end of the first current limiting resistor is connected with a second power supply end; an emitter of the first transistor is connected with the first ballast resistor, the other end of the first ballast resistor is connected with an input end and is further connected with a base of the fourth transistor; an emitter of the fourth transistor is connected with the ground potential end, a collector of the fourth transistor is connected with an output end, and is further connected with the first inductor, and the other end of the first inductor is connected with a first power supply end.

6. The radio frequency front-end module having a current protection function according to claim 5, wherein

when the bias circuit, the power amplification circuit and the protection unit satisfy following formulas, the bias circuit and the power amplification circuit enter a current limiting protection working state:

$$V_{1C} < V_{1b} - V_{th\_bc}$$

$$V_{1C} = VDD - VR$$

$$V_R = I_1 * R$$

$V_{1c}$ denotes a collector voltage of the first transistor, $V_{1b}$ denotes a base voltage of the first transistor, $V_{th\_bc}$ denotes a threshold voltage between the base and the collector of the first transistor, $V_R$ denotes a voltage drop on the first current limiting resistor, Ii denotes a collector current of the first transistor, R denotes a resistance value of the first current limiting resistor, and VDD denotes a voltage of a second power supply.

7. The radio frequency front-end module having a current protection function according to claim 2, wherein a thermistor with a temperature coefficient is adopted as the current limiting resistor of the protection unit; for a power amplifier likely to burn out at a low temperature, a thermistor with a negative temperature coefficient is adopted as the current limiting resistor; and for a power amplifier likely to burn out at a high temperature, a thermistor with a positive temperature coefficient is adopted as the current limiting resistor.

8. The radio frequency front-end module having a current protection function according to claim 2, wherein the protection unit comprises a plurality of different-size filter capacitors, so as to filter radio frequency signals and envelope signals different in frequency and realize broadband filtering.

9. The radio frequency front-end module having a current protection function according to claim 5, wherein a stabilized voltage supply with a temperature coefficient is adopted as a power supply connected with the first current limiting resistor in the protection unit; for a power amplifier likely to burn out at the low temperature, a stabilized voltage supply with a positive temperature coefficient is adopted as the power supply; and for a power amplifier likely to burn out at the high temperature, a stabilized voltage supply with a negative temperature coefficient is adopted as the power supply.

10. The radio frequency front-end module having a current protection function according to claim 5, wherein the protection unit further comprises a trap circuit; and the trap circuit is formed by connecting one inductor and one capacitor in series, and the trap circuit and the second filter capacitor are connected in parallel, an inductor end of the trap circuit being connected with node ends of the first current limiting resistor and the second filter capacitor, and a capacitor end being connected with the ground potential end.

11. The radio frequency front-end module having a current protection function according to claim 2, wherein the protection unit further comprises an inductor constituting an RLC combined circuit together with the current limiting resistor and the filter capacitor, to further filter the radio frequency signals and the envelope signals.

12. The radio frequency front-end module having a current protection function according to claim 11, wherein

the RLC combined circuit comprises an eleventh inductor, the current limiting resistor, an eleventh capacitor and a twelfth capacitor;
one end of the current limiting resistor is connected with a collector of a first transistor in a bias circuit, and is further connected with the eleventh capacitor; the other end of the current limiting resistor is connected with the eleventh inductor and is further connected with the twelfth capacitor; the other end of the eleventh inductor is connected with a second power supply end; and the other end of the eleventh capacitor and the other end of the twelfth capacitor are respectively connected with a ground potential end.

13. The radio frequency front-end module having a current protection function according to claim 1, further comprising a control switch, wherein the control switch is connected to two ends of the protection unit in parallel, so as to realize turn-on or turn off of the protection unit; and a control signal end of the control switch is connected with a first power supply end or an output end of a power detection circuit.

14. An electronic device, comprising the radio frequency front-end module having a current protection function according to any one of claims 1 to 13.

VCC

PAIN — Input matching — PA — Output matching — PAOUT

VDD

Vreg

Power supply module

## FIG. 1

VCC

1 — Input matching
2 — PA
3 — Output matching

PAIN

PAOUT

Protection unit

4 — Power supply module
5 — VDD

Vreg

## FIG. 2

VCC1    VCC2    VCC3

PAIN

PA1    PA2    PA3    PAOUT

Vreg1    Vreg2    Vreg3

Protection unit

VDD

Power supply module

4

2

5

## FIG. 3

Vreg

VDD

VCC

R1

C    R

L1

I1

IN

I2

Bias    V1c

HBT1

OUT

HBT2

R2

HBT4

HBT3    C1

## FIG. 4(a)

FIG. 4(b)

FIG. 5

FIG. 6

FIG. 7

FIG. 8

FIG. 9

FIG. 10

FIG. 11

FIG. 12

FIG. 13

FIG. 14

FIG. 15

## INTERNATIONAL SEARCH REPORT

| International application No. |
| --- |
| **PCT/CN2023/072885** |

**A.    CLASSIFICATION OF SUBJECT MATTER**

H03F 1/52(2006.01)i;H03F 3/213(2006.01)i;H03F 3/195(2006.01)i

According to International Patent Classification (IPC) or to both national classification and IPC

**B.    FIELDS SEARCHED**

Minimum documentation searched (classification system followed by classification symbols)

IPC: H03F

Documentation searched other than minimum documentation to the extent that such documents are included in the fields searched

Electronic data base consulted during the international search (name of data base and, where practicable, search terms used)

CNABS; CNTXT; CNKI; WPABS; DWPI; USTXT; WOTXT; EPTXT: 输入匹配, 功率放大器, 输出匹配, 电源, 保护, 射频, input matching, power amplifier, output matching, power, protection, radio frequency, RF

**C.    DOCUMENTS CONSIDERED TO BE RELEVANT**

| Category* | Citation of document, with indication, where appropriate, of the relevant passages | Relevant to claim No. |
| --- | --- | --- |
| PX | CN 114070212 A (VANCHIP (TIANJIN) TECHNOLOGY CO., LTD.) 18 February 2022 (2022-02-18) claims 1-10, and description, paragraphs [0005]-[0047] | 1-14 |
| X | US 2009256637 A1 (PANASONIC CORP.) 15 October 2009 (2009-10-15) description, paragraphs [0043]-[0094], and figures 1-18 | 1-4, 7, 8, 11-14 |
| Y | US 2009256637 A1 (PANASONIC CORP.) 15 October 2009 (2009-10-15) description, paragraphs [0043]-[0094], and figures 1-18 | 5, 6, 9, 10 |
| Y | CN 110677132 A (GUANGZHOU SUIYUAN MICROELECTRONICS TECHNOLOGY CO., LTD.) 10 January 2020 (2020-01-10) description, paragraph [0004], and figure 1 | 5, 6, 9, 10 |
| Y | US 2014375390 A1 (RF MICRO DEVICES, INC.) 25 December 2014 (2014-12-25) description, paragraphs [0026]-[0034], and figure 1 | 5, 6, 9, 10 |
| A | CN 111740710 A (VANCHIP (TIANJIN) TECHNOLOGY CO., LTD.) 02 October 2020 (2020-10-02) entire document | 1-14 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **14 March 2023** | **06 April 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

INTERNATIONAL SEARCH REPORT
Information on patent family members

International application No.

**PCT/CN2023/072885**

| Patent document cited in search report | | | Publication date (day/month/year) | Patent family member(s) | | | Publication date (day/month/year) |
|---|---|---|---|---|---|---|---|
| CN | 114070212 | A | 18 February 2022 | None | | | |
| US | 2009256637 | A1 | 15 October 2009 | US | 7872532 | B2 | 18 January 2011 |
| | | | | JP | 2009253918 | A | 29 October 2009 |
| CN | 110677132 | A | 10 January 2020 | CN | 110677132 | B | 25 September 2020 |
| US | 2014375390 | A1 | 25 December 2014 | US | 9337787 | B2 | 10 May 2016 |
| CN | 111740710 | A | 02 October 2020 | WO | 2021244565 | A1 | 09 December 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009256637 A1